# EUROPÄISCHE PATENTSCHRIFT

(11) **EP 3 879 650 B1**
(45) Veröffentlichungstag und Bekanntmachung des Hinweises auf die Patenterteilung: **03.04.2024**
(21) Anmeldenummer: 21156238.4
(22) Anmeldetag: 10.02.2021
(51) Int. Cl.: H02G 11/02

(54) **KABELTROMMEL ZUR ENERGIEVERSORGUNG EINES ELEKTRISCH BETRIEBENEN NUTZFAHRZEUGS**
CABLE REEL FOR ENERGY SUPPLY OF AN ELECTRIC OPERATED COMMERCIAL VEHICLE
ENROULEUR DE CÂBLE DESTINÉ À L'ALIMENTATION EN ÉNERGIE D'UN VÉHICULE UTILITAIRE À COMMANDE ÉLECTRIQUE

(30) Priorität: 13.03.2020 DE 102020203282
(43) Veröffentlichungstag der Anmeldung: 15.09.2021
(73) Patentinhaber: Deere & Company, Moline, IL 61265 (US)
(72) Erfinder: KLEIN, ANDRE, 68163 Mannheim (DE); TARASINSKI, NICOLAI, 68163 Mannheim (DE); PFAFFMANN, SIMON, 68163 Mannheim (DE); KEGEL, VOLKER, 68163 Mannheim (DE); KOESTERMEYER, THORSTEN, 68163 Mannheim (DE)
(74) Vertreter: Dehnhardt, Florian Christopher

(56) Entgegenhaltungen:
- DE-C- 765 071
- JP-A- S62 260 512
- JP-U- H0 231 279
- US-A- 2 330 086

## Beschreibung

Die Erfindung bezieht sich auf eine Kabeltrommel zur Energieversorgung eines elektrisch betriebenen Nutzfahrzeugs, mit einem axial verlaufenden Wickelkörper, der sich zum Auf- und Abspulen eines elektrischen Kabels um eine Rotationsachse in Drehung versetzen lässt.

Eine derartige Kabeltrommel geht beispielsweise aus der JP S 62 260512 A hervor, die einen durch stirnseitige Flansche begrenzten Trommelkörper zum Aufwickeln eines Verlängerungskabels umfasst. Je nach zu übertragender elektrischer Leistung kommt es aufgrund induktiver Verluste zu einer mehr oder minder starken Erwärmung des aufgewickelten Kabels. Um einer möglichen Überhitzung entgegenzuwirken, ist an einem der stirnseitigen Flansche ein Axiallüfter angeordnet, der Luft aus der Umgebung ansaugt und in Richtung des Innern des Trommelkörpers befördert. Eine Vielzahl von in einer zylindrischen Wandung des Trommelkörpers verteilt ausgebildeten Öffnungen erlaubt einen Austritt der Luft in Richtung des aufgewickelten Kabels, wobei die Verlustwärme von dem erzeugten Luftstrom über durch Abstandsstäbe gebildete Freibereiche an dessen Windungen vorbei nach außen abgeführt wird. Eine ähnliche Kabeltrommel ist aus der DE 765 071 C bekannt, welche die Merkmale des Oberbegriffs des Anspruchs 1 offenbart.

Es ist Aufgabe der vorliegenden Erfindung, eine Kabeltrommel der eingangs genannten Art hinsichtlich der Abfuhr verlustbedingt entstehender Abwärme in den Windungen eines auf den Wickelkörper aufgespulten Kabels zu optimieren.

Diese Aufgabe wird durch eine Kabeltrommel mit den Merkmalen des Patentanspruchs 1 gelöst.

Die Kabeltrommel zur Energieversorgung eines elektrisch betriebenen Nutzfahrzeugs umfasst einen axial verlaufenden Wickelkörper, der sich zum Auf- und Abspulen eines elektrischen Kabels um eine Rotationsachse in Drehung versetzen lässt. Hierbei trägt der Wickelkörper auf einer Innenseite eine Vielzahl von Lüftern, die zur Erzeugung eines bezüglich einer zylindrischen Trommelwandung radial nach außen gerichteten Kühlluftstroms ausgebildet sind. Genauer gesagt wird mittels der Lüfter ein forcierter Luftstrom erzeugt, der unmittelbar auf die Windungen eines auf den Wickelkörper aufgespulten Kabels trifft und auf diese Weise für eine besonders effiziente Abfuhr der darin verlustbedingt entstehenden Abwärme sorgt.

Die Lüfter können als elektrisch angetriebene Axiallüfter ausgebildet sein, wobei diese über Schleifkontakte, die im Bereich einer drehbaren Aufhängung des Wickelkörpers angeordnet sind, von außen mit Strom versorgt werden.

Bei dem elektrisch angetriebenen Nutzfahrzeug handelt es sich beispielsweise um eine Land-, Forst- oder Baumaschine, die auf einem abgegrenzten Areal einen zugehörigen Arbeitsvorgang ausführt. Lediglich beispielhaft sei hier das Pflügen eines Felds mittels eines landwirtschaftlichen Traktors, ein mittels eines Mähdreschers oder eines Holzvollernters ausgeführter Erntevorgang, Baggerarbeiten mittels eines Schaufelladers in einer Kiesgrube, und dergleichen erwähnt.

Vorteilhafte Weiterbildungen der erfindungsgemäßen Kabeltrommel gehen aus den Unteransprüchen hervor.

Erfindungsgemäß sind die Lüfter in Reihen jeweils entlang der Rotationsachse des Wickelkörpers angeordnet, wobei mehrere Reihen von Lüftern entlang eines Innenumfangs der zylindrischen Trommelwandung verteilt angeordnet sind. Auf diese Weise lassen sich die Windungen eines auf den Wickelkörper aufgespulten Kabels mittels des Kühlluftstroms flächig beaufschlagen. Dem Entstehen unerwünschter lokaler Hitzeherde innerhalb der Windungen des Kabels kann so zuverlässig entgegengewirkt werden. Die Lüfter sind insbesondere derart angeordnet, dass deren Luftaustrittsrichtung jeweils bezüglich der zylindrischen Trommelwandung radial nach außen weist.

Des Weiteren ist es denkbar, dass die Lüfter mittels einer Trägerplatte auf der Innenseite des Wickelkörpers befestigt sind, wobei der Kühlluftstrom über eine zwischen Trägerplatte und Innenseite verlaufende Luftführung zu einer jeweiligen Luftaustrittsöffnung in der zylindrischen Trommelwandung geleitet wird. Insbesondere besteht in einem solchen Fall die Möglichkeit, den mittels eines einzelnen Lüfters erzeugten Kühlluftstrom auf mehrere benachbarte Luftaustrittsöffnungen zu verteilen. Trägerplatte und Luftführung können beispielsweise als einstückiges Kunststoffspritzgussteil hergestellt sein. Die so gebildete Baugruppe wird dann auf der Innenseite des Wickelkörpers luftdicht mit der zylindrischen Trommelwandung verbunden.

Um eine möglichst ungehinderte Abfuhr der Abwärme zu ermöglichen, kann im Bereich der Austrittsöffnung ein Separierungsmittel vorgesehen sein, mittels dessen benachbarte Windungen eines auf den Wickelkörper aufgespulten Kabels lagenweise zur Bildung eines Luftdurchtrittsbereichs auf Abstand gehalten werden.

Das Separierungsmittel kann auf unterschiedliche Art und Weise verwirklicht sein. So ist es möglich, dass es sich bei diesem um entlang eines Außenumfangs des Wickelkörpers angeordnete Stäbe und/oder um eine entlang eines Außenumfangs des Wickelkörpers verlaufende Erhebung handelt. Bevorzugt bestehen die Stäbe aus Stahl mit einer zum Schutz des Kabels aufgebrachten Kunststoffbeschichtung. Die Erhebung hingegen kann in Gestalt eines schraubenförmig umlaufenden Rückens ausgebildet sein. Dieser kann einstückig an der zylindrischen Trommelwandung des Wickelkörpers ausgeformt sein.

Im Sinne der baulichen Vereinfachung der Kabeltrommel kann aus Kostengründen auch auf ein Separierungsmittel verzichtet werden. Die einzelnen Windungen des auf den Wickelkörper aufgespulten Kabels liegen dann mehr oder minder aneinander, wobei der Kühlluftstrom durch dazwischen (zufällig) gebildete Lücken hindurchtritt.

Die erfindungsgemäße Kabeltrommel zur Energieversorgung eines elektrisch betriebenen Nutzfahrzeugs wird im Folgenden anhand der beigefügten Zeichnungen näher erläutert. Hierbei sind übereinstimmende bzw. bezüglich ihrer Funktion vergleichbare Komponenten mit denselben Bezugszeichen gekennzeichnet. Es zeigen:
- Fig. 1: eine perspektivische Ansicht eines Ausführungsbeispiels der erfindungsgemäßen Kabeltrommel,
- Fig. 2: eine Schnittdarstellung der in Fig. 1 wiedergegebenen Kabeltrommel mit einem Separierungsmittel gemäß einer ersten Ausführung, und
- Fig. 3: eine Schnittdarstellung der in Fig. 1 wiedergegebenen Kabeltrommel mit einem Separierungsmittel gemäß einer zweiten Ausführung.

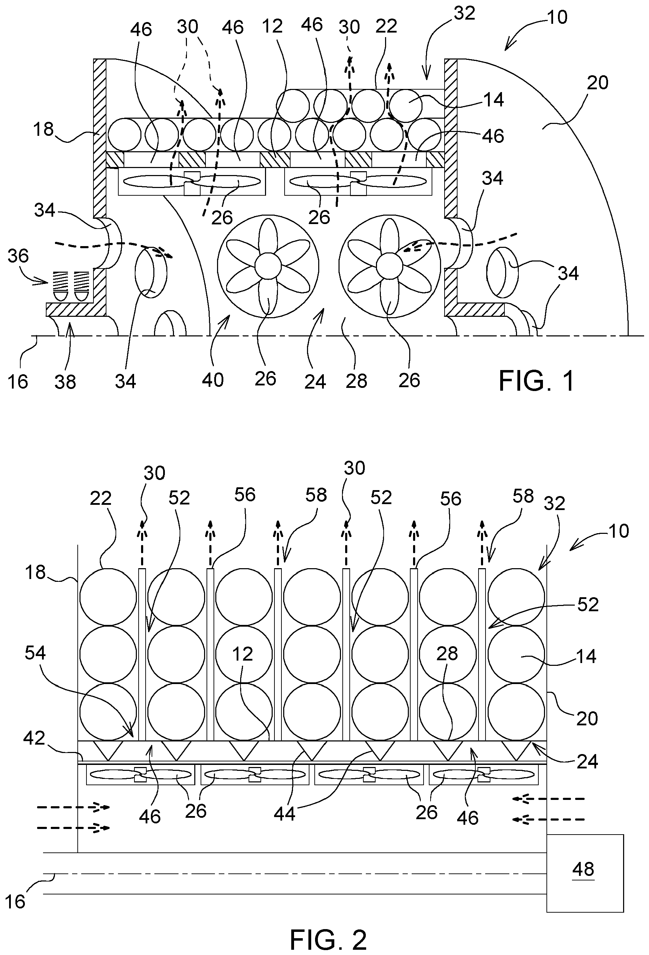

Fig. 1 zeigt eine perspektivische Ansicht eines Ausführungsbeispiels der erfindungsgemäßen Kabeltrommel zur Energieversorgung eines elektrisch betriebenen Nutzfahrzeugs. Die Kabeltrommel ist insbesondere Bestandteil einer Anordnung, wie sie in der DE 10 2018 212 150 A1 für den Fall eines als Feldhäcksler ausgebildeten Nutzfahrzeugs beschrieben ist.

Die Kabeltrommel 10 umfasst einen axial verlaufenden Wickelkörper 12, der sich zum Auf- und Abspulen eines elektrischen Kabels 14 um eine Rotationsachse 16 in Drehung versetzen lässt. Hierzu steht der Wickelkörper 12 mit einem nicht gezeigten elektromotorischen Antrieb des Nutzfahrzeugs in Verbindung. Linke und rechte Abschlussflansche 18, 20 bilden eine axiale Begrenzung des Wickelkörpers 12.

Das Kabel 14 dient in erster Linie der Energieversorgung des Nutzfahrzeugs und umfasst eine Vielzahl von aus Kupfer bestehenden Einzeladern, die gegeneinander isoliert in einem schützenden Außenmantel 22 verlaufen. Zusätzlich kann das Kabel 14 der elektrischen und/oder optischen Datenübertragung dienen. In einem solchen Fall umfasst das Kabel 14 weitere Adern in Gestalt entsprechender Daten- und/oder Steuerleitungen. Eine optische Datenübertragung erfolgt dabei mittels kunststoffummantelter Lichtleiter.

Wie in Fig. 1 zu erkennen ist, trägt der Wickelkörper 12 auf einer Innenseite 24 eine Vielzahl von Lüftern 26, die zur Erzeugung eines bezüglich einer zylindrischen Trommelwandung 28 radial nach außen gerichteten Kühlluftstroms 30 ausgebildet sind. Genauer gesagt wird mittels der Lüfter 26 ein forcierter Luftstrom erzeugt, der unmittelbar auf die Windungen 32 des auf den Wickelkörper 12 aufgespulten Kabels 14 trifft. In den linken und rechten Abschlussflanschen 18, 20 ausgebildete Öffnungen 34 erlauben eine Ansaugung von Luft aus der Umgebung.

Bei den Lüftern 26 handelt es sich vorliegend um elektrisch angetriebene Axiallüfter, wobei diese über Schleifkontakte 36, die im Bereich einer drehbaren Aufhängung 38 des Wickelkörpers 12 angeordnet sind, von außen mit Strom versorgt werden.

Beispielsgemäß sind die Lüfter 26 in Reihen jeweils entlang der Rotationsachse 16 des Wickelkörpers 12 angeordnet. Mehrere Reihen von Lüftern 26 sind entlang eines Innenumfangs 40 der zylindrischen Trommelwandung 28 verteilt angeordnet. Auf diese Weise lassen sich die Windungen 32 des auf den Wickelkörper 12 aufgespulten Kabels 14 mittels des Kühlluftstroms 30 flächig beaufschlagen. Die Lüfter 26 sind derart angeordnet, dass deren Luftaustrittsrichtung jeweils bezüglich der zylindrischen Trommelwandung 28 radial nach außen weist.

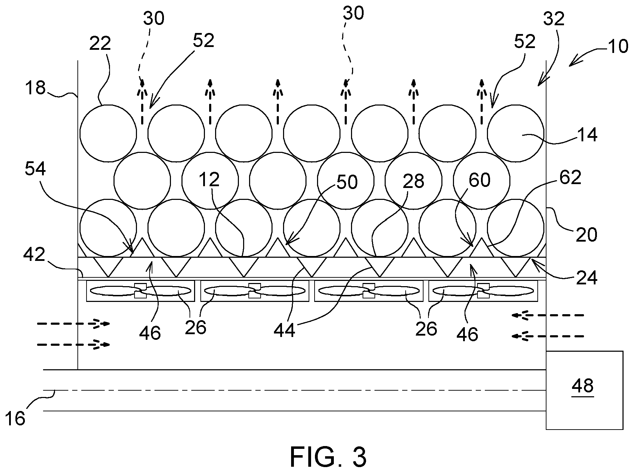

Gemäß Fig. 2 bzw. Fig. 3 sind die Lüfter 26 mittels einer Trägerplatte 42 auf der Innenseite 24 des Wickelkörpers 12 befestigt, wobei der Kühlluftstrom 30 über eine zwischen Trägerplatte 42 und Innenseite 24 verlaufende Luftführung 44 zu einer jeweiligen Luftaustrittsöffnung 46 in der Trommelwandung 28 geleitet wird. Solchermaßen wird der mittels eines einzelnen Lüfters 26 erzeugte Kühlluftstrom 30 auf mehrere benachbarte Luftaustrittsöffnungen 46 verteilt. Trägerplatte 42 und Luftführung 44 sind als einstückiges Kunststoffspritzgussteil hergestellt. Die so gebildete Baugruppe ist auf der Innenseite 24 des Wickelkörpers 12 luftdicht mit der zylindrischen Trommelwandung 28 verbunden.

Die Drehzahl der Lüfter 26 wird in Abhängigkeit des Bewicklungsgrads der Kabeltrommel 10 angepasst. So nimmt der Umfang der abzuführenden Abwärme naturgemäß mit geringer werdender Anzahl aufeinanderliegender Kabellagen ab. Die abgewickelte bzw. auf dem Wickelkörper 12 verbliebende Kabellänge wird mittels eines mit der Rotationsachse 16 verbundenen Drehgebers 48 bestimmt. Hierzu wird die mittels des Drehgebers 48 erfasste Anzahl an Umdrehungen sowie die Drehrichtung des Wickelkörpers 12 ausgewertet. Zusätzlich erfolgt eine Berücksichtigung der über das Kabel 14 übertragenen elektrischen Leistung auf Grundlage einer sensorischen Messung der Stromstärke. Dabei wird die Drehzahl der Lüfter 26 und damit die Luftzufuhr mit geringer werdender Anzahl an Kabellagen bzw. abnehmender Stromstärke reduziert.

Um eine möglichst ungehinderte Abfuhr der Abwärme zu ermöglichen, ist im Bereich jeder der Luftaustrittsöffnungen 46 ein Separierungsmittel 50 vorgesehen, mittels dessen benachbarte Windungen 32 eines auf den Wickelkörper 12 aufgespulten Kabels 14 lagenweise zur Bildung eines Luftdurchtrittsbereichs 52 auf Abstand gehalten werden.

Das Separierungsmittel 50 kann auf unterschiedliche Art und Weise verwirklicht sein. Mögliche Ausführungen sind in Fig. 2 und Fig. 3 abgebildet.

Im Falle einer in Fig. 2 dargestellten ersten Ausführung des Separierungsmittels 50 handelt es sich um entlang eines Außenumfangs 54 des Wickelkörpers 12 angeordnete Stäbe 56. Die Stäbe 56 bestehen aus Stahl mit einer zum Schutz des Kabels 14 aufgebrachten Kunststoffbeschichtung.

Die Luftaustrittsöffnungen 46 befinden sich unterhalb eines von den Stäben 56 jeweils gebildeten Freibereichs 58. Der austretende Kühlluftstrom 30 kann somit ungehindert entlang der Windungen 32 des auf den Wickelkörper 12 aufgespulten Kabels 14 vorbeistreichen und so die aufgestaute Abwärme nach außen mitführen.

Alternativ handelt es sich im Falle einer in Fig. 3 abgebildeten zweiten Ausführung des Separierungsmittels 50 um eine entlang des Außenumfangs 54 des Wickelkörpers 12 verlaufende Erhebung 60. Die Erhebung 60 ist in Gestalt eines schraubenförmig umlaufenden Rückens 62 ausgebildet, der einstückig an der Trommelwandung 28 des Wickelkörpers 12 ausgeformt ist. Der Rücken 62 ist im Bereich der Luftaustrittsöffnungen 46 unterbrochen, um einen Durchtritt des Kühlluftstroms 30 nicht zu behindern.

## Patentansprüche

1. Kabeltrommel (10) zur Energieversorgung eines elektrisch betriebenen Nutzfahrzeugs, mit einem axial verlaufenden Wickelkörper (12), der sich zum Auf- und Abspulen eines elektrischen Kabels (14) um eine Rotationsachse (16) in Drehung versetzen lässt, wobei der Wickelkörper (12) auf einer Innenseite (24) eine Vielzahl von Lüftern (26) trägt, die zur Erzeugung eines bezüglich einer zylindrischen Trommelwandung (28) radial nach außen gerichteten Kühlluftstroms (30) ausgebildet sind, **dadurch gekennzeichnet, dass** die Lüfter (26) in mehreren Reihen jeweils entlang der Rotationsachse (16) des Wickelkörpers (12) und entlang eines Innenumfangs der zylindrischen Trommelwandung verteilt angeordnet sind, wobei der Kühlluftstrom (30) durch Luftaustrittsöffnungen (46) in der zylindrischen Trommelwandung (28) geleitet wird.

2. Kabeltrommel (10) nach Anspruch 1, **dadurch gekennzeichnet, dass** die Lüfter (26) mittels einer Trägerplatte (42) auf der Innenseite (24) des Wickelkörpers (12) befestigt sind, wobei der Kühlluftstrom (30) über eine zwischen Trägerplatte (42) und Innenseite (24) verlaufende Luftführung (44) zu einer jeweiligen Luftaustrittsöffnung (46) in der zylindrischen Trommelwandung (28) geleitet wird.

3. Kabeltrommel (10) nach Anspruch 1 oder 2, **dadurch gekennzeichnet, dass** im Bereich der Austrittsöffnung (46) ein Separierungsmittel (50) vorgesehen ist, mittels dessen benachbarte Windungen eines auf den Wickelkörper (12) aufgespulten Kabels (14) lagenweise zur Bildung eines Luftdurchtrittsbereichs auf Abstand gehalten werden.

4. Kabeltrommel (10) nach Anspruch 3, **dadurch gekennzeichnet, dass** es sich bei dem Separierungsmittel (50) um entlang eines Außenumfangs (54) des Wickelkörpers (12) angeordnete Stäbe (56) und/oder um eine entlang eines Außenumfangs (54) des Wickelkörpers (12) verlaufende Erhebung (60) handelt.

## Claims

1. Cable reel (10) for the energy supply of an electrically operated commercial vehicle, having an axially running winding body (12) which for winding and unwinding an electrical cable (14) can be set in rotation about a rotation axis (16), wherein the winding body (12) on an internal side (24) supports a multiplicity of fans (26) which are configured to generate a cooling air stream (30) directed radially outward in terms of a cylindrical reel wall (28), **characterized in that** the fans (26) are disposed so as to be distributed in a plurality of rows in each case along the rotation axis (16) of the winding body (12) and along an internal circumference of the cylindrical reel wall, wherein the cooling air stream (30) is directed through air outlet openings (46) in the cylindrical reel wall (28).

2. Cable reel (10) according to Claim 1, **characterized in that** the fans (26) are fastened by means of a support plate (42) on the internal side (24) of the winding body (12), wherein the cooling air stream (30), by way of air routing (44) running between the support plate (42) and the internal side (24), is directed to a respective air outlet opening (46) in the cylindrical reel wall (28).

3. Cable reel (10) according to Claim 1 or 2, **characterized in that** provided in the region of the outlet opening (46) is a separation means (50) by means of which adjacent windings of a cable (14) wound up on the winding body (12) are held so as to be spaced apart in tiers in order to form an air passage region.

4. Cable reel (10) according to Claim 3, **characterized in that** the separation means (50) are bars (56) which are disposed along an external circumference (54) of the winding body (12), and/or an elevation (60) which runs along an external circumference (54) of the winding body (12) .

## Revendications

1. Tambour de câble (10) pour l'alimentation en énergie d'un véhicule utilitaire à commande électrique, avec un corps d'enroulement (12) s'étendant axialement, qui peut être mis en rotation autour d'un axe de rotation (16) pour envider et dévider un câble électrique (14), le corps d'enroulement (12) portant sur un côté intérieur (24) une pluralité de ventilateurs (26), configurés pour générer un courant d'air de refroidissement (30) dirigé radialement vers l'extérieur par rapport à une paroi de tambour cylindrique (28), **caractérisé en ce que** les ventilateurs (26) sont agencés en étant répartis en plusieurs rangées respectivement le long de l'axe de rotation (16) du corps d'enroulement (12) et le long d'une périphérie intérieure de la paroi de tambour cylindrique, le courant d'air de refroidissement (30) étant guidé à travers des ouvertures de sortie d'air (46) dans la paroi de tambour cylindrique (28).

2. Tambour de câble (10) selon la revendication 1, **caractérisé en ce que** les ventilateurs (26) sont fixés sur le côté intérieur (24) du corps d'enroulement (12) au moyen d'une plaque de support (42), le courant d'air de refroidissement (30) étant guidé vers une ouverture de sortie d'air respective (46) dans la paroi de tambour cylindrique (28) via un guide d'air (44) s'étendant entre la plaque de support (42) et le côté intérieur (24).

3. Tambour de câble (10) selon la revendication 1 ou 2, **caractérisé en ce qu'**il est prévu dans la zone de l'ouverture de sortie (46) un moyen de séparation (50) au moyen duquel des spires voisines d'un câble (14) envidé sur le corps d'enroulement (12) sont maintenues à distance couche par couche pour former une zone de passage d'air.

4. Tambour de câble (10) selon la revendication 3, **caractérisé en ce que** le moyen de séparation (50) consiste en des barres (56) agencées le long d'une périphérie extérieure (54) du corps d'enroulement (12) et/ou en un bossage (60) s'étendant le long d'une périphérie extérieure (54) du corps d'enroulement (12).
